**Europäisches Patentamt**

**European Patent Office**

**Office européen des brevets**

(11) Veröffentlichungsnummer: **0 166 941**

**A2**

(12) # EUROPÄISCHE PATENTANMELDUNG

(21) Anmeldenummer: 85106266.1

(22) Anmeldetag: 22.05.85

(51) Int. Cl.⁴: **H 03 K 17/94**
**H 05 B 37/00**

(30) Priorität: 05.06.84 CH 2726 84

(43) Veröffentlichungstag der Anmeldung:
08.01.86 Patentblatt 86/2

(84) Benannte Vertragsstaaten:
AT BE CH DE FR GB IT LI LU NL SE

(71) Anmelder: Züblin, Marcel Dipl.-Ing. ETH
Tachlisbrunnenstr. 28
CH-8400 Winterthur(CH)

(72) Erfinder: Reichlin, Anton
Im Grafenstein 41
CH-8408 Winterthur(CH)

(72) Erfinder: Züblin, Marcel
Tachlisbrunnenstrasse 28
CH-8400 Winterhur(CH)

(74) Vertreter: Troesch, Hans Alfred, Dr. Ing. et al,
Walchestrasse 19
CH-8035 Zürich(CH)

(54) Verfahren ind Steuerung u.a. zur Verhinderung lastbedingter Schalterzustandsbeeinflussung.

(57) Zur Ansteuerung einer Last, wie einer Raumbeleuchtung (37) mittels eines elektronischen, infrarotgesteuerten Schalters wird die Spannung ($U_{AB}$) über der Schalterstrekke (A, B) einer AC/DC-Wandlung (39) mit Spannungsbegrenzung unterzogen. Die Ausgangsspannung dient der Elektronikspeisung ($U_{39=}$). Der Infrarotsensor (41) steuert über Komparatoren (43, 60) eine wiedersetzbar monostabile Einheit (46) für das Aufschalten der Last an, was über eine Phasenabschnittschaltung (49, 51) für die Schalterstreckenspannung ($U_{AB}$) erfolgt. Zur Verhinderung, dass beim Abschalten der Beleuchtung eine Rückkopplung von der Lampe (37) auf den Sensor (41) eintritt, wird nach einer Lampenausschaltung der Einfluss des Sensors (41) auf den als Triac ausgebildeten Schalter (51) für eine vorgegebene Zeitspanne ($\tau_{59}$) gesperrt (60).

./...

EP 0 166 941 A2

FIG.4

- 1 -

## Verfahren und Steuerung u.a. zur Verhinderung lastbedingter Schalterzustandsbeeinflussung

Die vorliegende Erfindung betrifft erstens bei einer Steueranordnung mit einem Signalsensor und einem von dessen Ausgang angesteuerten Schalter für eine Last, die, bei Aufschaltung/Abschaltung u.a. Signale der vom Sensor detektierten Art erzeugt, ein Verfahren zur Verhinderung lastbedingter Schalterzustandsbeeinflussung sowie zweitens ein Verfahren zur elektronischen Schaltung eines Laststromkreises mittels Serieschalter, drittens ein Verfahren zur elektronischen Steuerung eines Serielastschalters mittels eines Signalsensors zur Ansteuerung des Schalters. Im weiteren betrifft die Erfindung eine elektronische Steuerung mit einem Lastschalter und einem Sensor, der mit seinem Ausgangssignal den Schalter ansteuert, eine elektronische Steuerung mit einem Serieschalter für eine Last sowie die Kombinationen der genannten Verfahren und Steuerungen.

Es ist bekannt, Lasten, wie beispielsweise am Netzwechselstrom betriebene Beleuchtungen, mittels Sensoren, wie beispielsweise Infrarotsensoren, anzuschalten. Es wird damit erreicht, dass, wenn beispielsweise eine Person als Infrarotquelle einen Raum, mit einer derartigen Steueranordnung versehen, betritt, das Licht automatisch angezündet wird, und, nach Verlassen des Raumes, wieder gelöscht wird. Dabei wird die Sensibilität des Systems desto grösser je höher die dem Sensor nachgeschaltete Signalverstärkung gewählt wird. Mit erhöhter Sensibilität wird aber auch die Distanz vergrössert, in welcher eine Strahlungsquelle durch einen vorgesehenen Sensor noch detektiert wird.

Bei Erhöhung der dem Sensor nachgeschalteten Verstärkung ist jedoch zu berücksichtigen, dass je nach angesteuerter Last, wie die erwähnten Beleuchtungen, letztere ebenfalls Signale der vom Sensor detektierten Art abgeben, hier beispielsweise Infrarotstrahlung, sodass bei der erwähnten hohen Verstärkung eine Rückkopplung der Lastabstrahlung auf den Sensor zu unkontrollierten Systemschaltzuständen führen kann, dies vor allem bei Betriebstransienten. Ueblicherweise werden derartige Sensoren so betrieben, dass sie Signaländerungen und nicht stationäre Signalpegel detektieren. Deshalb sind, insbesondere bei der Aufschaltung resp. Abschaltung der Last entstehende Signale, wenn sie von der vom Sensor detektierten Art sind, im obgenannten Sinne gefährlich.

Es ist eine Aufgabe der vorliegenden Erfindung, bei einem Verfahren erstgenannter Art zu verhindern, dass Aenderungen im Betriebszustand der Last den Schalterzustand beeinflussen. Dies wird dadurch erreicht, dass man nach Auftreten eines Schalterzustands-Wechsels den neu eingenommenen Zustand für eine vorgegebene Zeitspanne einfriert. Dadurch wird erreicht, dass nach dieser Zeitspanne alle gefährlichen Signaltransienten von der Last, nach Betriebszustandsänderungen, d.h. Auf- oder Abschaltungen, abgeklungen sind. Bevorzugterweise wird, wenn der Sensor Signaländerungen detektiert, ein erstes Signal bei einer detektierten Signaländerung für eine vorgegebene Zeitspanne gesetzt und bei Auftreten weiterer Signaländerungen mit der Zeitspanne wiedergesetzt, wobei man bei Rückfallen des ersten Signals den Einfluss von der detektierten Signaländerung auf das erste Signal während einer weiteren vorgebbaren Zeitspanne sperrt. Gerade bei der Ansteuerung von Beleuchtungen mittels Infrarotsensoren soll die Beleuchtung ja solange aufgeschaltet bleiben, als sich jemand im Raum aufhält, was durch Detektion immer wieder auftretender Signaländerungen führt. Erst wenn während der ersten der angegebenen Zeitspannen keine Signaländerung mehr detektiert wird, wird die Beleuchtung abgeschaltet und die Sperrung des Sensoreinflusses während der weiteren vorgebbaren Zeitspanne vorgenommen. Somit wirken sich beim Löschen der Beleuchtung entstehende Strahlungsänderungen, die vom Sensor detektiert werden, nicht auf den Schalterzustand aus. Bei der letztgenannten Ansteuerungsart, sollen alle detektierten Signaländerungen zur Aufschaltung der Last führen. Eine dadurch bedingte Signaländerung kann somit ohnehin keinen Einfluss auf den Schalterzustand nehmen, sondern es ist lediglich im genannten Sinne das Abschaltverhalten zu sichern. Es können aber durchaus Fälle vorkommen, insbesondere wenn stationäre Signalwerte vom Sensor schaltwirksam detektiert werden, in denen beide Lasttransienten bezüglich der Schalteransteuerung unwirksam gemacht werden müssen.

Im weiteren ist es bekannt, dass Lasten, wie die genannten, am Wechselstromkreis betriebenen Beleuchtungen, über manuelle Schalter ohne Nulleiter, in Serie in den Laststromkreis geschaltet, angesteuert werden. Will man von diesen manuellen Schaltern auf elektronische Schalter übergehen, beispielsweise zur Ansteuerung der genannten Lasten über Infrarotsensoren, so entsteht das Problem, wie, insbesondere bei geschlossener Schalterstrecke, die Speisespannung für die eingesetzte Elektronik bereitgestellt werden soll.

Eine weitere Aufgabe der vorliegenden Erfindung ist es mithin, ein Verfahren zur elektronischen Schaltung eines Laststromkreises mittels Serieschalter vorzuschlagen, bei welchem dieses Problem gelöst wird. Dies wird dadurch erreicht, dass man bei Lastaufschaltung den Schalter sequentiell intermittierend öffnet und die Spannung über der Schalterstrecke zu einer DC-Spannung für die Speisung der Schaltersteuerung wandelt. Wird die Last beispielsweise an einem DC-Stromkreis betrieben, so liegt die DC-Spannung bei geöffneter Schalterstrecke über letzterer. Bei geschlossener Schalterstrecke liegt die Spannung über der Last. Da eine vorgesehene elektronische Schaltung über der Schalterstrecke ohne weitere Verkabelung vorzusehen ist, wird die Last bei ihrer Aufschaltung in gewissen sich folgenden Zeitabschnitten durch Oeffnen der Schalterstrecke, mit entsprechender Repetitionsfrequenz, vom Betriebsnetz abgetrennt, es entsteht über der Schalterstrecke eine pulsierende Gleichspannung, die erfasst und geglättet als DC-Spannung für die Speisung der Schaltersteuerung eingesetzt wird. Vor der Lastaufschaltung ist die Speisung, da der Schalter dann ohnehin geöffnet ist, sichergestellt. Dasselbe Prinzip wird für am Wechselstrom betriebene Laststromkreise eingesetzt, indem man dann mit dem Schalter die Spannung über der Schalterstrecke phasenanschneidet.

Wie bereits erwähnt, entstehen beispielsweise beim Einsatz der genannten sensorgesteuerten elektronischen Schaltungen für die Ansteuerung von Lasten, wie beispielsweise von Beleuchtungen, des öftern in Kombination beide Probleme, erstens dasjenige, das bei Erhöhung der Systemsensibilität, wie durch Verstär-

- 5 -

kungserhöhung, der Lastbetriebszustand den Schalterzustand beeinflussen kann, sowie zweitens dasjenige,
dass eine derartige Schaltung als Serieschalter ohne
zusätzliche Verkabelung eingesetzt werden sollte.
Deshalb wird das unter drittens erwähnte Verfahren
nach dem Wortlaut des Anspruchs 5 ausgebildet. Dabei
wird vorzugsweise davon ausgegangen, dass sich, ob im
Gleichstrom- oder im Wechselstrombetrieb, die Spannung
über der Schalterstrecke bei intermittierendem Schalterbetrieb gegenüber derjenigen bei offenem Schalter
ändert, m.a.W. verschieden ist, je nachdem, ob die
Last auf- oder abgeschaltet ist. Diese Aenderung wird
an der unmittelbar aus der Spannung über der Schalterstrecke gewonnenen Gleichspannung detektiert, die
bei Ausschaltung der Last höher ist als bei Aufschaltung und somit beim Wechsel vom einen Betriebszustand
zum andern ebenfalls ihren Wert ändert. Diese Aenderung zeigt an, dass einerseits die Last den neuen Betriebszustand eingenommen hat, und dass andererseits
allenfalls bereits detektierte, lastzustandswechselbedingte Signale, von der Beeinflussung des Schalterzustandes gesperrt werden müssen. Die DC-Spannung
hingegen, welche für die Speisung der Steuerschaltung
eingesetzt wird, sollte möglichst unabhängig vom
Lastbetriebszustand sein.

An einem Wechselstromlastkreis erzeugt man deshalb
die erste DC-Spannung, die Speisespannung, vorzugsweise durch spannungsbegrenzte AC/DC-Wandlung eines
vorzugsweise mit Amplitudenbegrenzung über der
Schalterstrecke abgegriffenen Signals.

Die elektronische Steuerung mit einem Lastschalter
und einem Sensor, der mit seinem Ausgangssignal den Schalter ansteuert, wie eingangs erwähnt, wird dadurch von insbesondere in Schalttransienten der Last erzeugten Signalen, der vom Sensor detektierten Art unempfindlich gemacht, dass eine Sperrschaltung vorgesehen ist, die nach mindestens einem der möglichen Zustandswechsel des ansteuernden Signals für eine vorgegebene Zeitspanne die Wirkung des Sensors auf den Schalter unterbricht und den eingenommenen Schalterzustand aufrecht erhält.

Liegt ein das Eingangssignal differenzierender Sensor vor, so wird bevorzugterweise der Sensorausgang auf eine wiedersetzbare, monostabile Einrichtung mit vorzugsweise einstellbarer Zeitkonstanten geführt, und es wird eine auf Abfallen der Einrichtung hin gesetzte weitere monostabile Einrichtung zwischen Sensor und Schalter vorgesehen, vorzugsweise mit ebenfalls einstellbarer Zeitkonstanten, wobei der Ausgang dieser monostabilen Einrichtung auf eine Signalsperre im Sensor-Schalter-Signalpfad wirkt. Somit bewirken alle vom Sensor detektierten Signaländerungen ein Setzen, resp. Wiedersetzen der ersten monostabilen Einrichtung und erst das Ausbleiben derartiger Signale und damit das Abfallen dieser Einrichtung, löst während der vorgebbaren Zeit die Signalsperre aus.

Eine weitere Aufgabe der Erfindung ist es, eine elektronische Steuerung mit einem Serieschalter für eine Last eingangs genannter Art zu schaffen, unter Berücksichtigung der bereits oben genannten Probleme für die Speisung der Steuerung, was durch Ausbildung gemäss Wortlaut von Anspruch 10 erreicht wird. Für einen AC-Lastkreis wird dabei vorzugsweise die Takt-

- 7 -

schaltung als Phasenanschnittschaltung für die Spannung über der Schalterstrecke ausgelegt.

Soll bei der letztgenannten elektronischen Steuerung zudem das Problem der Last/Sensor-Rückwirkung gelöst werden, so wird eine Steuerung nach Anspruch 11 vorgeschlagen.

Damit die Ausgangsspannung des die Speisespannung liefernden AC/DC-Wandlers vom Lastbetriebszustand unabhängig wird, wird weiter vorgeschlagen, dass dem Speisespannungs-AC/DC-Wandler eine Spannungsbegrenzung, wie eine Zener-Diodenschaltung zugeordnet ist.

Dadurch, dass bei den genannten Steuerungen der Sensor als IR-Sensor ausgebildet ist und sein Ausgang über eine Komparatorschaltung mit einstellbarer Referenzspannung und/oder mit einer, von einem zweiten Sensor angesteuerten Referenzspannung, auf den Schalter geführt wird, wird erreicht, dass einerseits mit der einstellbaren Referenzspannung die Ansprechschwelle der Steuerung eingestellt werden kann und andererseits, dass Umgebungsverhältnisse wie Tag/-Nacht-Unterschiede, durch den zweiten Sensor detektiert und, durch entsprechende Aenderung der Referenzspannung am erwähnten Komparator, berücksichtigt werden können. Es wird weiter vorgeschlagen, dass der Sensor über eine Komparatorschaltung auf den Schalter wirkt, und dass die Sperrung durch Beeinflussung dessen Referenzspannung erfolgt. Die beschriebenen Verfahren sowie die beschriebenen elektronischen Steuerungen in allen möglichen Kombinationen, eignen sich insbesondere für die Anwendung von Infrarotsensoren für die Ansteuerung von Raumbeleuchtungen.

- 8 -

Die Erfindung wird anschliessend beispielsweise anhand von Figuren erläutert.

Es zeigen:

Fig. 1: ein Funktionsblockdiagramm einer erfindungsgemässen Steuerung eines Lastschalters über einen Sensor, wobei nach jedem Schalterzustandswechsel der eingenommene Zustand eingefroren wird, zur Verhinderung des Einflusses von Last-Sensor-Schalterzustand-Rückwirkungen,

Fig. 2: ein Funktionsblockdiagramm einer weiteren Variante der erfindungsgemässen Anordnung von Fig. 1,

Fig. 3: ein Funktionsblockdiagramm einer erfindungsgemäss elektronischen Schaltersteuerung mit einem Serieschalter und der Speisung der Schaltung in einem AC- oder DC-Lastkreis,

Fig. 4: eine bevorzugte erfindungsgemässe Realisationsform in Funktionsblockdarstellung einer Infrarotsensor angesteuerten Serieschaltereinheit in einem Wechselstromlastkreis mit Speisung für die Elektronik und Last/Sensor-Beeinflussung verhindernder Sperrung.

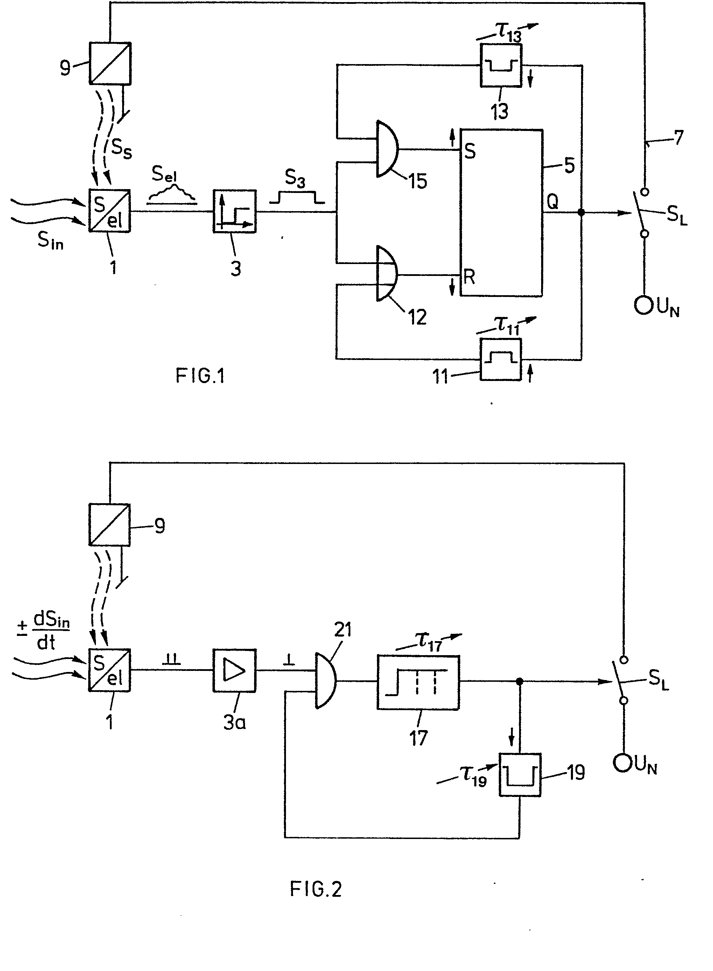

Gemäss Figur 1 wandelt ein Sensor 1, als Wandler dargestellt, Eingangssignale $S_{in}$, wie Infrarotstrahlung, ausgangsseitig in ein elektrisches Signal $S_{el}$, welch letzteres, allenfalls verstärkt, einer Komparatoreinheit 3 zugeführt wird, die, wenn das Eingangssignal $S_{el}$ diesseits eines Signalpe-

gels liegt, ein Ausgangssignal $S_3$ auf einem ersten Signalwert, ansonsten auf einem zweiten Signalwert, beispielsweise entsprechend logischen Signalpegeln '1' und '0' abgibt. Mit der aufsteigenden Signalflanke des Signals $S_3$ wird eine bistabile Einheit 5, wie ein Flip-flop, gesetzt, mit der abfallenden Signalflanke des Signals $S_3$ rückgesetzt. Der Ausgang Q der bistabilen Einheit 5 steuert einen Lastschalter $S_L$ in einen Stromkreis 7 für eine Last 9 an. Insbesondere beim Auf- resp. Ausschalten gibt die Last u.a. Signale $S_s$ der selben Art ab, wie sie als Signale $S_{in}$ vom Sensor 1 detektiert werden. So können bei einer Lampe sowohl beim Ein- wie auch beim Ausschalten Infrarotsignal-Aenderungen entstehen, die der Sensor 1, ein Infrarotsensor, schaltwirksam detektiert. Ohne weitere Vorkehrungen zu treffen, wird der Sensor, bei Wechsel des Betriebszustandes der Last 9 solche rückgekoppelten Signale $S_s$ detektieren und möglicherweise unmittelbar den Zustand des Lastschalters $S_L$ wieder wechseln. Um dies zu verhindern steuert die aufsteigende Signalflanke am Ausgang Q der bistabilen Einheit 5 eine erste monostabile Einheit 11 an, mit vorzugsweise einstellbarer Impulszeit $\tau_{11}$. Ueber eine ODER-Schaltung 12 mit dem Ausgang des Komparators 3 logisch verknüpft und auf den Rücksetzeingang R geführt, empfindlich auf abfallende Schaltflanken, verhindert der Ausgangsimpuls der Einheit 11, solange er ansteht, jegliches Abfallen des dem Rücksetzeingang R zugeführten Signals. Damit bleibt während $\tau_{11}$, entsprechend der beispielsweise eingetragenen Ansteuerrichtung, der Lastschalter $S_L$ geschlossen, auch wenn beim dadurch bewirkten Aufschalten der Last Streusignale $S_s$ auf den Sensor 1 fallen. Analog wird beim Abfallen des Ausgangssignals Q eine zweite monostabile Einheit 13 ausgelöst mit vorzugsweise einstellbarer Impulsdauer $\tau_{13}$, die mit einem Ausgangsimpuls eingezeichneter Polarität über eine UND-Einheit 15 mit dem Ausgang des Komparators 3 logisch verknüpft auf den Setzeingang der Einheit 5 wirkt, letztere auf aufsteigende Signalflanken ansprechend. Ist somit bei Abfallen des Signals am Ausgang Q der Schalter $S_L$ geöffnet worden, so wird während der Zeitspanne $\tau_{13}$ jegliche aufsteigende Signalflanke am Setzeingang S gesperrt: Der Schalter $S_L$ bleibt während dieser Zeitspanne in geöffneter Position gesperrt.

Ist nach Ablauf der Zeitspanne $\tau_{11}$ das Ausgangssignal $S_3$ auf hohem Signalpegel, so wird die Einheit 5 auch danach nicht rückgesetzt, der Schalter $S_L$ bleibt geschlossen. Ist hingegen dann das Signal $S_3$ auf tiefem Signalpegel, so fällt beim Abfallen des Ausgangsimpulses der Einheit 11 das Signal am Rücksetzeingang R ab und der Schalter $S_L$ wird geöffnet. Analoge Verhältnisse treten bezüglich des Setzeinganges S auf: Ist nach Ablauf der Zeitspanne $\tau_{13}$ das Signal $S_3$ auf tiefem Signalpegel, so bleibt der Eingang S ebenfalls tief, die Einheit 5 wird nicht gesetzt, der Schalter $S_L$ bleibt offen. Ist hingegen dann das Signal $S_3$ auf hohem Signalpegel, so wird die Einheit 5 am Ende des Ausgangsimpulses der Einheit 13 gesetzt. Auf diese Art und Weise werden durch das transiente Auf- und Abschalten der Last 9 bewirkte Einkopplungen an den vorgesehenen Sensor 1 schaltunwirksam gemacht.

Des öftern werden nun Sensoren eingesetzt, die ausgangsseitig elektrische Impulse der einen und/oder anderen Polarität abgeben, in Funktion von Signaländerungen $\frac{dS_{in}}{dt}$ am Sensoreingang. Treten derartige Signaländerungen auf und damit am elektrischen Sensorausgang elektrische Impulse, so wird dies, z.B. bei Infrarotsensoren zur Raumüberwachung, dahingehend interpretiert, dass eine zu detektierende Strahlungsquelle, wie ein Lebewesen, im überwachten Raume ist.

Soll bei einem derartigen Zustand, d.h. es treten in vorgegebener Minimalzeitabfolge Signaländerungen auf, eine Last wie eine Beleuchtung auf- resp. ansonsten ausgeschaltet werden, so wird der Ausgang des Sensors 1 allenfalls an einer Einheit 3a verstärkt und impulsgeformt, auf eine wiedersetzbare, monostabile Einheit 17 geschaltet, mit vorzugsweise einstellbarer

Ausgangsimpulsdauer $\tau_{17}$. Treten detektierte Signaländerungen $\pm \frac{dS_{in}}{dt}$ in Zeitabständen kürzer als $\tau_{17}$ auf,

so bleibt beispielsweise der schalterschliessende Zustand am Ausgang der Einheit 17 bestehen. Wie mit +/- angedeutet, registriert der Sensor sowohl eine Zu- wie Abnahme des detektierten Signals, was eine Erhöhung der Informationsdichte ergibt.


Beim Aufschalten der Last 9 sich ergebende und vom Sensor 1 detektierte Signaländerungen können diesen Zustand des Schalters $S_L$ nicht beeinträchtigen, da während der vorgebbaren Zeitspanne $\tau_{17}$ dieser einmal

ausgelöste Signalzustand dadurch aufrechterhalten bleibt. Treten nun während einer gesetzten oder wiedergesetzten Zeitspanne $\tau_{17}$ keine detektierten Signaländerungen mehr auf, so wird nach Verstreichen    - dieser Zeitspanne das Ausgangssignal der Einheit 17 abfallen. Dies bewirkt ein Oeffnen des Lastschalters

$S_L$. Nun ist ersichtlich, dass ohne Vorkehrungen, dieser Betriebszustandswechsel an der Last 9, falls er durch letztere eine genügend signifikante Signaländerung am Eingang des Sensor 1 bewirkt, die Einheit 17 unmittelbar wieder auslösen wird, wodurch der Schalter $S_L$ wieder geschlossen wird. Es kann dabei ein pendelndes Auf- und Abschalten des Schalters $S_L$ entstehen, wobei er nur kurzzeitig geöffnet bleibt. Um dies zu verhindern wird bei abfallender Signalflanke des Ausgangssignals der Einheit 17 eine in Analogie zur Einheit 13 von Figur 1 wirkende monostabile Einheit 19 ausgelöst, die einen, wie eingezeichnet, polaren Impuls der vorzugsweise einstellbaren Zeitdauer $\tau_{19}$ abgibt. Rückgeführt gegen den Sensor 1 hin wird dadurch an einer UND-Einheit 21 verhindert, dass unmittelbar nach Oeffnen des Schalters $S_L$ detektierte, an sich schaltwirksame Signaländerungen, die wiedersetzbare monostabile Einheit 17 wieder auslösen können.

Anhand dieser beiden Beispiele wird klar, wie die erfindungsgemässe Sperre nach Umschaltvorgängen am Schalter $S_L$ grundsätzlich realisiert wird, wobei sich selbstverständlich dem Fachmann viele Möglichkeiten zur Realisation dieser Sperrung eröffnen.

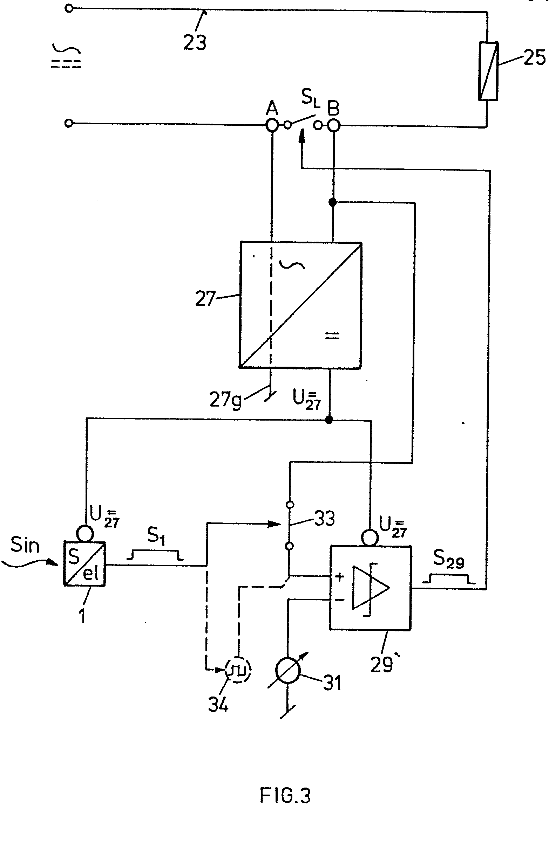

In Figur 3 ist ein Blockdiagramm dargestellt zur Erläuterung des Aufbaus eines elektronisch betriebenen Lastschalters, in einem Laststromkreis 23. Der Laststromkreis 23 mit einer Last 25, wie einer Lampe, weist wie üblich eine Schalterstrecke AB auf, die herkömmlicherweise durch einen manuell betätigbaren Schalter geschlossen resp. geöffnet wird. Ziel der Anordnung gemäss Figur 3 ist es, einen elektronisch wirkenden Schalter, ausgelöst beispielsweise durch einen Sensor 1 analog zu demjenigen in den Figuren 1 oder 2 dargestellt, zu betreiben, ohne dass weitere elektrische Anschlüsse über die Anschlüsse AB der Schalterstrecke hinaus, vorgesehen werden müssen.

Beim Kreis 23 handle es sich vorerst um einen Wechselstromkreis wie einen mit Netzwechselspannung betriebenen Kreis. Ueber den Anschlüssen AB liegt ein AC/DC Wandler 27, der, vorerst bei geöffnetem Lastschalter $S_L$, die über der Schalterstrecke AB liegende Wechselspannung in eine Ausgangsgleichspannung $U_{27=}$ wandelt, bezogen auf "electronic ground" bei 27g. Diese Spannung wird zur Speisung der vorgesehenen elektronischen Komponenten, wie bei $U_{S1}$, $U_{S31}$ eingetragen, verwendet. Ab Erzeugung eines lastschalterschliessenden, d.h. Last 25 aufschaltenden Steuersignals, wie eines Signals S1 am Ausgang des Sensors 1, wird die über den Anschlüssen AB liegende Wechselspannung auf eine Komparatoreinheit 29 mit an einer einstellbaren Quelle 31 veränderlichem Referenzwert aufgeschaltet, und gibt im Takte der Netzfrequenz und nach Massgabe des Vergleichs des Netzsignals mit dem Referenzsignal, Ausgangsimpulse S29 ab, welche den elektrisch ansteuerbaren Lastschalter $S_L$ intermittierend schliessen und öffnen. Im geschlossenen Zustand steht die Last 25 unter Spannung, im geöffneten Zustand der AC/DC-Wandler 27, der nun die geschnittene Wechselspannung an den Anschlüssen AB in eine Gleichspannung für die Elektronikspeisung wandelt. Vorzugsweise wird der Ausgangsgleichspannungswert $U_{27=}$ des Wandlers 27 begrenzt auf einen Wert, der höchstens so hoch ist, wie er sich bei intermittierend betriebenem Lastschalter $S_L$ einstellt. Dadurch wird sichergestellt, dass die Speisespannung $U_{27=}$ unabhängig vom Schalterbetriebszustand ist. Das Auf- resp.

- 14 -

Abschalten der Netzspannung auf den Komparator 29
wird nach Massgabe des Sensorausgangssignals Sl, wie
schematisch mit dem Schalter 33 dargestellt, vorgenommen.

Handelt es sich beim Stromkreis 23, wie gestrichelt
eingetragen, um einen Gleichstromkreis, so ändert
sich prinzipiell an der Funktionsweise der dargestellten Schaltung nichts. Anstelle der Ausnützung
der Netzwechselspannung für die Steuerung des intermittierenden Oeffnens und Schliessens des Lastschalters $S_L$ wird ein Taktgenerator 34 vorgesehen, der
durch das Ausgangssignal des Sensors 1 ausgelöst, die
intermittierende Ansteuerung des Lastschalters $S_L$
ansteuert. Handelt es sich beim AC/DC-Wandler für
Wechselspannungsbetrieb beispielsweise um eine
Gleichrichter/Glättungseinheit, so wird es sich für
Gleichspannungsbetrieb vorzugsweise um eine mittelwertsbildende Schaltung, wie ein Tiefpassfilter entsprechend gewählter Grenzfrequenz, handeln.

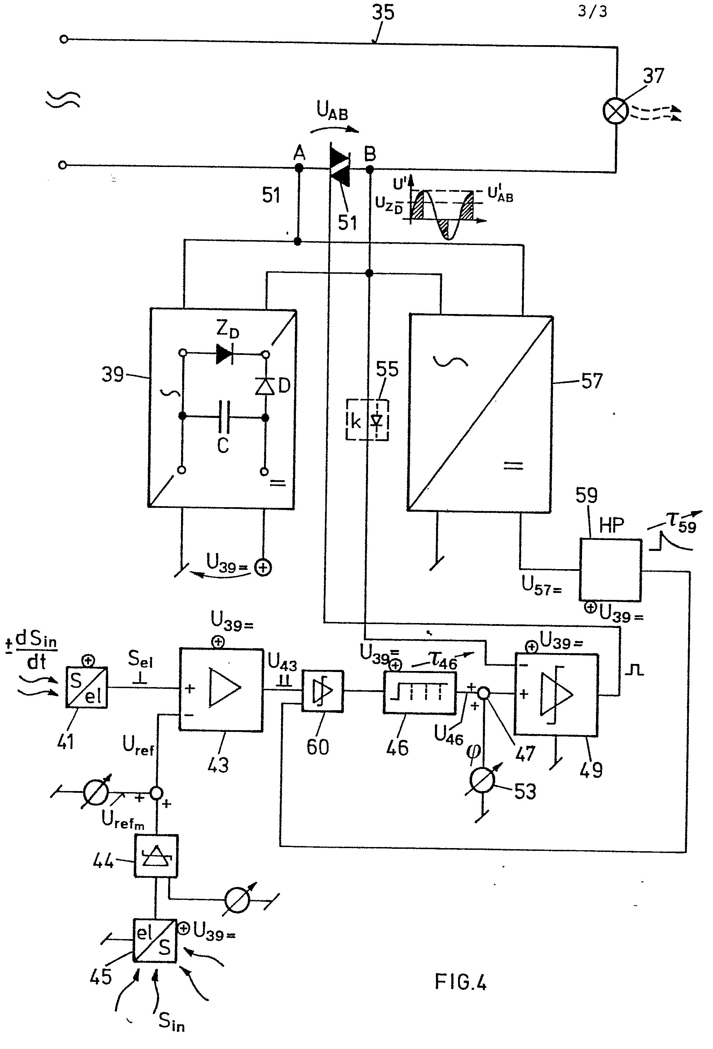

In Figur 4 ist eine bevorzugte Ausführungsform eines
sensorangesteuerten elektronischen Schalters, als
Serieschalter in einem Laststromkreis angeordnet, wie
ein Infrarotsensor-gesteuerter Schalter für Raumbeleuchtungen dargestellt. Der Wechselstromlastkreis 35
mit einer Last 37, hier als Lampe dargestellt, weist
eine Schalterstrecke AB auf, in welche üblicherweise
ein manuell betätigter Schalter angeordnet ist. Die
Spannung $U_{AB}$ über der Schalterstrecke AB wird, in Analogie zu den Ausführungen zu Figur 3, vorerst einem
ersten AC/DC-Wandler 39 zugeführt, der aus der Schalterstreckenspannung $U_{AB}$ durch Gleichrichtung und
Amplitudenbegrenzung wie an einer Zener-Diode ZD, und

- 15 -

Glättung wie an einer Glättungskondensator/Dioden-schaltung CD, die Speisespannung $U_{39=}$ für die zu speisende und noch zu beschreibende Elektronik bereitstellt. Durch Vorsehen der Amplitudenbegrenzung, wie mit der Diode ZD, wird sichergestellt, dass die Spannung $U_{AB}$ in grossen Bereichen ändern kann, ohne dass sich die Ausgangsspannung $U_{39=}$ der Einheit 39 ändert. Ein in Analogie zu den Ausführungen zu Figur 1 wirkender Sensor 41, beispielsweise ein Infrarotsensor, wandelt detektierte Signaländerungen $\pm \frac{dS_{in}}{dt}$ , durch differenzierendes Verhalten, in Ausgangsimpulse $S_{el}$ um. Diese werden einer dem Sensor 41 nachgeschalteten Komparatorschaltung 43 zugeführt, welch letzterer zusätzlich eine manuell einstellbare Referenzspannung $U_{refm}$ zugespiesen wird, überlagert durch die Ausgangsspannung eines weiteren Komparators 44, dessen Eingang mit einem weiteren Sensor 45, wie einem Helligkeitssensor verbunden ist. Der Sensor 45 resp. dessen Ausgang wirkt via Komparator 44 als umgebungsverhältnisabhängige Referenzspannung auf die Komparatoreinheit 43. An der Komparatoreinheit 43 werden Ausgangsimpulse $U_{43}$ erzeugt, nach Massgabe des an der Komparatoreinheit 43 erfolgenden Vergleiches der Eingangsimpulse $S_{el}$ mit der eingespiesenen Referenzspannung $U_{ref}$. Mit den am Ausgang der Komparatoreinheit 43 erscheinenden Impulsen wird grundsätzlich eine wiedersetzbare, monostabile Einrichtung 46 ausgelöst, der vorzugsweise einstellbaren Zeitkonstanten $\tau_{46}$. Das Ausgangssignal der monostabilen Einrichtung 46 wird über eine Ueberlagerungseinheit 47 einer weiteren Komparatorschaltung 49 zugeführt, welch letzterer als zweitem Eingang die Schalterstreckenspannung $U_{AB}$ zugeführt ist. Der Ausgang der Komperatorschaltung 49 wirkt auf einen elektrisch steuerbaren Schalter über der Schalterstrecke AB, wie eine Triac 51. An der Ueberlagerungseinheit 47 wird das Ausgangssignal der monostabilen Einrichtung 46 DC-mässig im Pegel verschoben. Der Referenzwert für die Komparatoreinheit 49 wird an der einstellbaren Quelle 53 so gestellt, dass bei einem Ausgangssignal an der Einheit 46, entsprechend gesetzter Einheit, die Schalterspannung $U_{AB}$ bei bereits relativ kleinem Phasenwinkel $\varphi$ den Referenzwert erreicht und einen Signalwechsel am Ausgang der Einheit 49 bewirkt. Ist die monostabile Einrichtung 46 hingegen nicht gesetzt, so erreichen die Amplitudenwerte der Spannung $U_{AB}$ den Referenzwert nicht. Es versteht sich von selbst, dass vor der Zuspeisung der Schalterstreckenspannung $U_{AB}$ an die Komparatoreinheit 49, wie gestrichelt dargestellt, eine Gleichrichtung allenfalls mit Abschwächung k, an einer vorgeschalteten Einheit 55 vorgenommen werden kann. Die bis dahin dargestellte Steuerung funktioniert wie folgt: Wird am Eingang des Sensors 41 eine Signaländerung $\pm \dfrac{dS_{in}}{dt}$ detektiert, so erscheint am Sensorausgang der Impuls $S_{el}$. Ist die detektierte Signaländerung genügend gross, dass der Sensorausgangsimpuls den Referenzwert $U_{ref}$ an der Komparatoreinheit 43 überschreitet, so erscheint auch an deren Ausgang ein Impuls $U_{43}$, der die wiedersetzbare monostabile Einrichtung 46 setzt. Diese bleibt so lange gesetzt als in Zeitabständen, die kleiner sind als ihre Zeitkonstante $\tau_{46}$, wiederum am Sensor 41 Signaländerungender angegebenen Grösse aufgenommen werden. Durch Setzen der Einrichtung 46 wird der Komparatoreinheit 49 dasjenige Referenzsignal gesetzt, welches bei bereits relativ geringem Phasenwinkel $\varphi$ der Schalterstreckenspannung

$U_{AB}$ erreicht wird, wobei in diesem Zustand bei noch nicht leitend geschaltetem Triac 51 die gesamte Netzspannung über der Strecke AB liegt. Beim vorgegebenen Netzspannungsphasenwinkel $\varphi$ erreicht die Spannung $U_{AB}$ den Referenzwert an der Komparatorschaltung 49, worauf deren Ausgang den Triac 51 zündet. Er bleibt bekannterweise bis zum nächstfolgenden Strom Null-Durchgang gezündet, wobei während der gezündeten Zeitspanne die Netzspannung über der Last 37 liegt, über der Strecke AB hingegen praktisch Null-Spannung. Verbleibt die monostabile Einrichtung 46 durch entsprechende Abfolge von detektierten Signaländerungen gesetzt, erfolgt somit ein kontinuierlicher Phasenanschnitt der Spannung $U_{AB}$, die dann den mit $U'_{AB}$ dargestellten Verlauf annimmt. In diesem Betriebszustand, d.h. bei aufgeschalteter Last 37, würde bei einer AC/DC-Wandlung, wie mit dem Wandler 39, ohne zusätzliche Massnahmen, die entstehende Ausgangsgleichspannung absinken. Mit Vorsehen der Amplitudenbegrenzung, wie mit der Zener-Diode $Z_D$, und Begrenzung auf einen Wert $U_{ZD}$ unterhalb des dem Phasenanschnittwinkel $\varphi$ entsprechenden Wertes $U'$ bleibt die Ausgangsspannung $U_{39=}$ des Wandlers 39, auch bei Auslösung der Phasenanschnittsteuerung, konstant. Treten während den Zeitspannen $\tau_{46}$ keine Signaländerungen $\pm \dfrac{dS_{in}}{dt}$ auf, so fällt die monostabile Einrichtung 46 ab, der Referenzwert $U_{46}$ an der Komparatoreinrichtung 49 verändert sich so, dass auch die Netzspannungsspitzenwerte den Referenzwert nicht mehr erreichen. Es erscheinen am Ausgang der Komparatoreinheit 49 keine den Triac 51 zündenden Signale mehr.

Nun ist es, wie bereits beschrieben worden ist, möglich, dass beim Ausschalten der Last 37 schaltersignifikante Signaländerungen $\pm \frac{dS_{in}}{dt}$ erzeugt werden,
welche die monostabile Einrichtung 46 unmittelbar
wieder auflösen würden. Um dies zu verhindern ist im
oben beschriebenen Sinne eine Sperrschaltung vorgesehen. Hierzu liegt über der Schalterstrecke AB ein
weiterer AC/DC-Wandler 57, der ohne Amplitudenbegrenzung, beispielsweise durch Diodengleichrichtung und
anschliessender Glättung, die Wechselspannung über
der Strecke AB in eine Gleichspannung $U_{57=}$ wandelt. Diese Spannung verändert sich nun je nachdem,
ob die volle Netzspannung über der Strecke AB liegt,
oder diese Spannung, im Lastaufschaltbetrieb, phasengeschnitten ist. In letzterem Fall fällt sie ab.
Somit ist das Ausgangssignal des Wandlers 57 repräsentativ für den Betriebszustand der Last. Steigt die
Ausgangsspannung $U_{57=}$ an, so besagt dies, dass
die Last 37 durch Sperren des Triac's 51 ausgeschaltet worden ist. Diese Signaländerung wird mittels
eines differenzierenden Netzwerkes 59, wie eines
Hochpasses, mit der Zeitkonstanten $\tau_{59}$, welche
vorzugsweise einstellbar ist, detektiert und das Ausgangssignal dieses Netzwerkes 59 wirkt so auf einen
Komparator 60, der zwischen Komparator 43 und
bistabile Einheit 46 geschaltet ist, dass während
einer Zeitspanne, entsprechend der eingestellten
Zeitkonstanten $\tau_{59}$, auch ein Setzen der wiedersetzbaren monostabilen Einrichtung 46 verhindert
wird. Somit werden, während der der Zeitkonstanten
$\tau_{59}$ entsprechenden Zeitspanne vom Sensor 41 erfasste
Signaländerungen unwirksam gemacht.

- 19 -

Es versteht sich von selbst, dass als Kriterium des Abschaltens der Lampe 37 z.B. auch das Ausgangssignal der Einrichtung 46 verwendet werden kann.

Mit Hilfe der beschriebenen Anordnungen ist es möglich, mit Hilfe eines Infrarotsensors hoher Sensibilität, damit grosser Detektionsdistanz, eine ausserordentlich automatische Schaltung von Raumbeleuchtungen vorzunehmen.

Patentansprüche:

1. Bei **einer** Steueranordnung mit einem Signalsensor (41) **und** einem von dessen Ausgang angesteuerten Schalter (SL; 51) für eine Last (9, 25, 37), die, bei **Aufschaltung/Abschaltung** u.a. Signale der vom Sensor detektierten Art ($S_{in}$, $\frac{dS_{in}}{dt}$) erzeugt, ein Verfahren zur Verhinderung lastbedingter Schalterzustandsbeeinflussung, dadurch gekennzeichnet, dass **man** nach Auftreten eines Schalterzustandswechsels den neu eingenommenen Zustand für eine vorgegebene Zeitspanne ($\tau_{11}$, $\tau_{13}$; $\tau_{17}$, $\tau_{19}$; $\tau_{45}$, $\tau_{59}$) einfriert.

2. Verfahren nach mindestens einem der Ansprüche, wie nach Anspruch 1, wobei der Sensor Signaländerungen ($\pm \frac{dS_{in}}{dt}$) detektiert, dadurch gekennzeichnet, **dass man** ein erstes Signal ($U_{46}$) bei einer detektierten Signaländerung für eine vorgegebene Zeitspanne ($\tau_{17}$, $\tau_{45}$) setzt und bei Auftreten weit Signaländerungen mit der Zeitspanne ($\tau_{17}$, $\tau_{45}$), wiedersetzt, und dass man bei Rückfallen des ersten Signals den Einfluss von detektierten Signaländerungen ($\pm \frac{dS_{in}}{dt}$) auf das erste Signal während einer weiteren vorgebbaren Zeitspanne ($\tau_{19}$, $\tau_{59}$) sperrt.

3. Verfahren, allenfalls nach mindestens einem der Ansprüche, zur elektronischen Schaltung eines Laststromkreises mittels Serieschalter, dadurch gekennzeichnet, dass man bei Lastaufschaltung den Schalter (SL; 51) sequentiell intermittierend öffnet, die Spannung $U_{AB}$ über der Schalterterstrecke (AB) zu einer DC-Spannung ($U_{27=}$, $U_{37=}$) für die Schaltersteuerung wandelt.

4. Verfahren, vorzugsweise nach mindestens einem der Ansprüche, wie nach Anspruch 3, in einem Wechselstromlastkreis, dadurch gekennzeichnet, dass man mit dem Schalter (51) die Spannung über der Schalterstrecke (AB) phasenanschneidet.

5. Verfahren, allenfalls nach mindestens einem der Ansprüche, zur elektrischen Steuerung eines Serielastschalters, mittels eines Signalsensors (41) zur Ansteuerung des Schalters (51), dadurch gekennzeichnet, dass man nach Auftreten eines lastaufschaltenden Sensorausgangssignals, den Schalter (51) intermittierend öffnet, die Spannung über der Schalterstrecke (AB) zu einer ersten DC-Spannung ($U_{37=}$) wandelt, für die Speisung der Schaltersteuerung mit einem wenigstens weitgehend Schalterbetriebszustand unabhängigen Ausgangssignalwert, und - wie vorzugsweise mit einer zweiten DC-Spannung ($U_{57=}$) mit einem, zu der über der Schalterstrecke (AB) proportionalen Wert -, den Lastbetriebszustand detektiert, und dass man Aenderungen dieses Betriebszustandes - wie der zweiten DC-Spannung - zur Sperrung der Sensor-Schalterbeeinflussung (59, 47), während einer vorgebbaren Zeitspanne ($\tau_{59}$) auswertet.

6. Verfahren, vorzugsweise nach mindestens einem der Ansprüche, wie nach Anspruch 5, an einem Wechselstromlastkreis, dadurch gekennzeichnet, dass man die erste DC-Spannung ($U_{37=}$) durch spannungsbe-

grenzte AC/DC-Wandlung eines vorzugsweise mit Amplitudenbegrenzung über der Schalterstrecke (AB) abgegriffenen Signals gewinnt.

7. Verfahren, vorzugsweise nach mindestens einem der Ansprüche, wie nach Anspruch 5, an einem Wechselstromlastkreis, dadurch gekennzeichnet, dass man das intermittierende Oeffnen durch Phasenanschnitt (51) realisiert.

8. Elektronische Steuerung, allenfalls nach mindestens einem der Ansprüche, mit einem Lastschalter (SL; 51) und einem Sensor (41), der mit seinem Ausgangssignal den Schalter ansteuert, dadurch gekennzeichnet, dass eine Sperrschaltung (5, 11, 12, 13, 15; 19, 21; 57, 59, 47, 49) vorgesehen ist, die nach mindestens einem der möglichen Zustandswechsel des ansteuernden Signals, für eine vorgegebene Zeitspanne ($\tau_{11}$, $\tau_{13}$, $\tau_{59}$) die Wirkung des Sensors (1, 41) auf den Schalter (SL; 51) unterbricht und den eingenommenen Schalterzustand aufrechterhält.

9. Elektronische Steuerung, vorzugsweise nach mindestens einem der Ansprüche, wie nach Anspruch 8, mit einem das Eingangssignal differenzierenden Sensor (1, 41), dadurch gekennzeichnet, dass der Sensorausgang auf eine wiedersetzbare, monostabile Einrichtung (17, 45) mit vorzugsweise einstellbarer Zeitkonstante ($\tau_{17}$, $\tau_{45}$) wirkt, dass eine auf Abfallen der Einrichtung (17, 45) hin gesetzte weitere monostabile Einrichtung (19, 59) vorgesehen ist, vorzugsweise einstellbarer Zeitkonstante ($\tau_{19}$, $\tau_{59}$) und dass der Aus-

gang der weiteren monostabilen Einrichtung (19, 59) auf eine Signalsperre (21, 47, 60) im Sensor/ Schalter-Signalpfad (1, SL) wirkt.

10. Elektronische Steuerung, allenfalls nach mindestens einem der Ansprüche, mit einem Serieschalter (SL; 51) für eine Last (25, 37), dadurch gekennzeichnet, dass eine Taktschaltung (33, 34, 49) vorgesehen ist, die den Schalter (SL; 51) zur Lastaufschaltung intermittierend öffnet und schliesst, und ein AC/DC-Wandler (27, 39) über der Schalterstrecke (AB), dessen Ausgang die Speisespannung ($U_{27=}$, $U_{39=}$) für die Steuerung ist.

11. Elektronische Steuerung, vorzugsweise nach mindestens einem der Ansprüche, wie nach Anspruch 10, für einen Wechselstromlastkreis wie für Netzbetrieb, dadurch gekennzeichnet, dass die Taktschaltung eine Phasenanschnittschaltung (49, 51) für die Spannung ($U_{AB}$) über der Schalterstrecke (AB) ist.

12. Elektronische Steuerung, vorzugsweise nach mindestens einem der Ansprüche, wie nach den Ansprüchen 8 und 10, dadurch gekennzeichnet, dass eine Zustandswechsel-Detektoreinheit vorgesehen ist, wie ein weiterer AC/DC-Wandler (57) über der Schalterstrecke (AB), von der das Ausgangssignal auf die Sperrschaltung (59, 47) wirkt, wie Ausgangssignaländerungen des weiteren AC/DC-Wandlers.

13. Elektronische Steuerung, vorzugsweise nach mindestens einem der Ansprüche, wie nach Anspruch 12, für einen Wechselstromlastkreis, dadurch gekennzeichnet, dass die Taktschaltung eine Phasenanschnittschaltung (49, 51) für die Spannung über der Schalterstrecke (AB) ist.

14. Elektronische Steuerung, vorzugsweise nach mindestens einem der Ansprüche, wie nach einem der Ansprüche 10 bis 13, dadurch gekennzeichnet, dass dem Speisespannungs-AC/DC-Wandler eine Spannungsbegrenzung, wie eine Zener-Diodenschaltung eingangsseitig zugeordent ist.

15. Elektronische Steuerung, vorzugsweise nach mindestens einem der Ansprüche 8 - 14, dadurch gekennzeichnet, dass der Sensor (41) ein Infrarotsensor ist, und dass sein Ausgang über eine Komparatorschaltung (43) mit einstellbarer Referenzspannung ($U_{refm}$) und/oder mit einer, von einem zweiten Sensor (45) angesteuerten Referenzspannung, auf den Schalter (51) wirkt.

16. Elektronische Steuerung, vorzugsweise nach mindestens einem der Ansprüche, wie nach einem der Ansprüche 8 bis 15, dadurch gekennzeichnet, dass der Sensor (41) über eine Komparatorschaltung (60) auf den Schalter (51) wirkt, und dass die Sperrung durch Beeinflussung seiner Referenzspannung erfolgt.

17. Verwendung des Verfahrens nach mindestens einem der Ansprüche und/oder der Steuerung, nach mindestens einem der Ansprüche, für die automatische Beleuchtungssteuerung in Räumen mittels eines Infrarotsensors.

FIG.1

FIG.2

FIG.3

FIG.4